# EUROPEAN PATENT APPLICATION

(11) **EP 4 811 953 A1**
(43) Date of publication of application: **23.09.2026**
(21) Application number: 25165250.9
(22) Date of filing: 21.03.2025
(51) Int. Cl.: H10B 43/30, H10D 30/69, H10D 64/01, H10D 64/66

(54) **NAND FLASH MEMORY DEVICE AND METHOD FOR FABRICATING A NAND FLASH MEMORY DEVICE**

(71) Applicant: Imec VZW, 3001 Leuven (BE)
(72) Inventor: Verreck, Devin, 3212 Pellenberg (BE); Rosmeulen, Maarten, 3001 Leuven (BE)
(74) Representative: Roth, Sebastian

(57) **Abstract**

The disclosure relates to a NAND flash memory device (10). The NAND flash memory device (10) comprises: a semiconductor channel layer (12) extending along a first axis; a first dielectric layer (13) arranged above the semiconductor channel layer (12); a charge storage layer (14) arranged on the first dielectric layer (13); a second dielectric layer (15) arranged on the charge storage layer (14); and a plurality of gate structures (19) arranged above the second dielectric layer (15) and along the first axis; wherein each gate structure (19) comprises a first section (16) and a second section (17), wherein the first section (16) and the second section (17) are designed to have different work functions, and wherein the first section (16) and the second section (17) are arranged next to each other along the first axis.

## Description

### TECHNICAL FIELD

The present disclosure relates to a NAND flash memory device and to a method for fabricating a NAND flash memory device. The present disclosure further relates to a method for operating a NAND flash memory device.

### BACKGROUND

NAND flash memory is a memory type which stores information in a non-volatile way in the form of charge carriers (electrons and/or holes) in a charge trap layer or a floating gate that is part of a flash cell transistor. The concentration of stored charge carriers corresponds to the bits of information and can be read by a resulting threshold voltage shift of the flash cell. Often, quantum tunneling is utilized to change the charge carrier concentrations, thereby writing or erasing information. To limit the threshold voltage variability among cells in the programmed state, a scheme called incremental step pulse programming (ISPP) is used, in which a set of pulses with increasing amplitude is applied to the gate until the threshold voltage target is achieved. A plot of the threshold voltage shift relative to the fresh state as a function of the pulse amplitude is called the ISPP curve, and provides important information on the performance of the flash cell.

To increase bit densities, the dimensions of the flash cells have been scaled down over successive technology generations. Since around 2015, the dominant technology in production has transitioned from planar devices to vertical, 3D structures, in which the flash memory string consists of a cylindrical memory hole along which the flash cells are stacked. The memory string can thus be fabricated by first depositing a stack of alternating layers, followed by an etch of the memory hole and a filling of the hole with the memory and channel layers. These 3D structures allow bit density to be increased by adding more cells to the strings, rather than scaling the cell dimensions. With the increasing number of cells on a string, however, etching of the memory hole becomes more challenging as the aspect ratio increases. This has resulted in a renewed push to scale down the vertical cell pitch, which is comprised of the flash cell gate length and the inter-gate spacing.

Both the transition from floating gate to charge trap layers and the continuing scaling of the cell have led to a degradation in the programming behavior, which is characterized by the programming onset and efficiency. The programming onset is defined as the voltage at which a significant threshold voltage shift of the cell is observed. In an ISPP plot, this corresponds to the point where the curve starts going up. The programming efficiency is the rate of change in the cell threshold voltage with increasing applied voltage. In an ISPP plot, this corresponds to the slope of the curve in the quasi-linear regime. Both these metrics (onset and efficiency) determine the voltage that is required to reach the target threshold voltage shift that corresponds with the programmed state of the cell. Lower programming voltages are generally desirable, as generating high voltages on chip is costly. In addition, a high programming efficiency is beneficial for the disturb behavior of the cell, as it increases the difference between the threshold voltage shift that occurs during pass mode versus programming mode. It also increases the window between different programming levels in multi-level cell operation.

Gate side injection has been proposed to improve the programming behavior of (scaled) flash cells. In this scheme, electrons are injected from the gate, rather than from the channel during the program operation. In this way, the capacitive coupling that determines the field compensation during the program operation is decoupled from the capacitive coupling that determines the impact of the programmed charge on the channel threshold voltage. If the memory stack is designed such that capacitance toward the gate is smaller than towards the channel side, an ISPP slope larger than the conventional maximum of 1 can be obtained. An added advantage is that gate side injection reduces the degradation of the oxide next to the channel, which improves cycling endurance.

While gate side injection can significantly improve the program operation compared to conventional channel side injection, erase is typically strongly degraded. This is because erase requires the injection of holes into the charge trap layer, which recombine with the present electrons and provide positive charge to offset the programmed threshold voltage (V_{T}) shift. In a conventional scheme, both electrons and holes can be injected from the channel side, which is comprised of an intrinsic or lowly doped semiconductor. For gate side injection, however, carriers are injected from the gate material, which conforms to requirements on the word line resistivity. However, known gate materials either benefit electron injection at the detriment of hole injection, or vice versa. There is no material which is optimal for both memory operations, program and erase, within the specification on the maximal resistivity.

### SUMMARY

Thus, it is an objective to provide an improved NAND flash memory device and an improved method for fabricating a NAND flash memory device. In particular, it is an objective to provide a NAND flash memory device capable of performing memory operations with high efficiency.

The objective is achieved by the embodiments provided in the enclosed independent claims. Advantageous implementations of the embodiments of the disclosure are further defined in the dependent claims.

A first aspect of this disclosure provides a NAND flash memory device, comprising: a semiconductor channel layer extending along a first axis; a first dielectric layer arranged above the semiconductor channel layer, a charge storage layer arranged on the first dielectric layer; a second dielectric layer arranged on the charge storage layer; and a plurality of gate structures arranged above the second dielectric layer and along the first axis; wherein each gate structure comprises a first section and a second section, wherein the first section and the second section are designed to have different work functions, and wherein the first section and the second section are arranged next to each other along the first axis.

This achieves the advantage that a NAND flash memory device is provided that allows for efficient memory operations (program and erase) via gate side injections. To achieve this advantage, the gate structures have a split gate design with a first section that can be optimized for gate side injection of electrons (for programming) and a second section that can be optimized for gate side injection of holes (for erasing).

For instance, the work function (and/or Fermi level) of the first section has a beneficial alignment with the edges of the second dielectric layer for electron injection, while the second section of the gate structures has a beneficial alignment for hole injection. As a result, the gate structures allow to efficiently inject electrons and holes into the charge storage layer (also referred to as: charge trap layer).

The second dielectric layer can be a tunnel oxide and/or the first dielectric layer can be a blocking oxide.

In an implementation form of the first aspect, the charge storage layer comprises a plurality of gaps which are arranged to interrupt the charge storage layer; wherein the gaps and the gate structures are alternately arranged along the first axis. This achieves the advantage that the injected carriers can be confined to a limited volume underneath the respective gates. This limited volume may be referred to as charge trap regions.

The gaps can extend to the first and/or second dielectric layer.

In an implementation form of the first aspect, the gaps are at least partially filled with air and/or an oxide material. This achieves the advantage that the charge carriers can be efficiently confined to the charge trap regions.

In an implementation form of the first aspect, the charge storage layer comprises a silicon nitride material.

In an implementation form of the first aspect, the work function of the first section of the respective gate structures ranges from 3.5. to 5 eV; and/or the work function of the second section of the respective gate structures ranges from 4.5 to 6 eV. This achieves the advantage that the first section can be optimized for electron injection and the second section can be optimized for hole injection.

In an implementation form of the first aspect, the work functions of the first section and the second section of the respective gate structures differ by at least 0.5 eV, preferably by at least 1 eV. For instance, the difference is between 1 and 2 eV.

In an implementation form of the first aspect, the first section and the second section of the respective gate structures comprise different materials and/or different dopings.

In an implementation form of the first aspect, the first section and/or the second section of the respective gate structures comprise a poly-silicon material, a metal or a metal nitride.

For example, the first and the second section can each be formed by a highly doped poly-Si or a metal. The first section can be made of an n-type material which highly benefits electron injection (e.g., n+ poly-Si), and the second section can be made of a p-type material which highly benefits hole injection (e.g., p+ poly-Si).

The metal can be any one of W, Ti, Ta, Al, Mo Ru, Co, Cu, Ir, or Pt. The metal nitride can be any one of TiN or TaN.

In an implementation form of the first aspect, the first and the second section of the respective gate structures have different widths along the first axis. This achieves the advantage that the gate structure can be further optimized for electron and hole injection.

In an implementation form of the first aspect, the respective gate structures comprise an isolating layer which is arranged between the first section and the second section. This achieves the advantage that the gate structure can be further optimized for electron and hole injection.

In an implementation form of the first aspect, each gate structure comprises a third section which is arranged next to the second section along the first axis; wherein the third section is designed to have the same work function as the first section, or wherein the third section is designed to have a work function that differs from the work function of the first section by less than 0.1 eV. This achieves the advantage that the gate structure can be further optimized for electron and hole injection.

For example, the first section and the third section of the respective gate structures are made from the same material(s). The second section can be made from a different material and sandwiched between the first and the third section.

A second aspect of this disclosure provides a method for operating the NAND flash memory device according to the first aspect of the disclosure, wherein the method comprises: applying a first bias to at least one of the gate structures to allow negative charge carriers, in particular electrons, to inject into the charge storage layer below the gate structure via the first section of the gate structure, wherein at least a portion of the negative charge carriers are stored in the charge storage layer; and applying a second bias to the at least one of the gate structures to allow positive charge carriers, in particular holes, to inject into the charge storage layer below the gate structure via the second section of the gate structure, wherein at least a portion of the positive charge carriers recombine with the negative charge carriers stored in the charge storage layer.

The application of the first bias may correspond to a programming (i.e., writing via electron injection), and the application of the second bias to an erasing (via hole injection).

A third aspect of this disclosure provides a method for fabricating a NAND flash memory device, the method comprising: forming a semiconductor channel layer extending along a first axis; forming a first dielectric layer arranged above the semiconductor channel layer; forming a charge storage layer arranged on the first dielectric layer; forming a second dielectric layer arranged on the charge storage layer; and forming a plurality of gate structures arranged above the second dielectric layer and along the first axis; wherein each gate structure comprises a first section and a second section, wherein the first section and the second section are designed to have different work functions, and wherein the first section and the second section are arranged next to each other along the first axis.

This achieves the advantage that a NAND flash memory device is provided that allows for efficient memory operations (program and erase) via gate side injection. To achieve this advantage, the gate structures have a split gate design with a first section that can be optimized for gate side electron injection (program) and a second section that can be optimized for gate side hole injection (erase).

In an implementation form of the third aspect, the method further comprises: forming a plurality of gaps in the charge storage layer; wherein the gaps are arranged to interrupt the charge storage layer; and wherein the gaps and the gate structures are alternately arranged along the first axis.

In an implementation form of the third aspect, the formation of the respective gate structures comprises: depositing a sacrificial layer above the second dielectric layer, selectively removing a first part of the sacrificial layer to expose a first area and depositing a material of the first section of the gate structure in the first area, and removing a second part of the sacrificial layer to expose a second area and depositing a material of the second section of the gate structure in the second area. This achieves the advantage that the sections of the gate structure can be formed in an efficient manner.

The first area and the second area can each comprise or be formed by a number of cavities in the sacrificial layer.

In an implementation form of the third aspect, the first part and the second part of the sacrificial layer are each removed via etching with an etchant, wherein the first part is designed to be etched with a higher etching rate than the second part.

The sacrificial layer can be formed from a silicon nitride (SiN) or a silicon-germanium (SiGe) material, wherein the respective nitride or germanium content of the SiN or SiGe material varies between the first part and the second part of the sacrificial layer.

In an implementation form of the third aspect, the gaps in the charge storage layer are at least partially filled with air and/or an oxide material.

In an implementation form of the third aspect, the charge storage layer comprises a silicon nitride material.

In an implementation form of the third aspect, the work function of the first section of the respective gate structures ranges from 3.5. to 5 eV; and/or the work function of the second section of the respective gate structures ranges from 4.5 to 6 eV.

In an implementation form of the third aspect, the work functions of the first section and the second section of the respective gate structures differ by at least 0.5 eV, preferably by at least 1 eV.

In an implementation form of the third aspect, the first section and the second section of the respective gate structures comprise different materials and/or different dopings.

In an implementation form of the third aspect, the first section and/or the second section of the respective gate structures comprise a poly-silicon material, a metal or a metal nitride.

In an implementation form of the third aspect, the first and the second section of the respective gate structures have different widths along the first axis.

In an implementation form of the third aspect, the respective gate structures comprise an isolating layer which is arranged between the first section and the second section.

In an implementation form of the third aspect, each gate structure comprises a third section which is arranged next to the second section along the first axis; wherein the third section is designed to have the same work function as the first section, or wherein the third section is designed to have a work function that differs from the work function of the first section by less than 0.1 eV.

### BRIEF DESCRIPTION OF THE DRAWINGS

The above-described aspects and implementations are explained in the following description of embodiments with respect to the enclosed drawings:
- FIG. 1: shows a schematic diagram of a NAND flash memory device according to an embodiment;
- FIGS. 2A to 2B: show results of simulations of memory operations in NAND flash memory devices according to an embodiment;
- FIG. 3: shows simulations of a charge carrier injection in a charge storage layer of a NAND flash memory device according to an embodiment;
- FIG. 4: a schematic diagram of a NAND flash memory device according to an embodiment;
- FIG. 5: a schematic diagram of a NAND flash memory device according to an embodiment;
- FIG. 6: a schematic diagram of a NAND flash memory device according to an embodiment;
- FIG. 7: a schematic diagram of a NAND flash memory device according to an embodiment; and
- FIGS. 8A to 8F: show steps of a method for fabricating a NAND flash memory device according to an embodiment;

### DETAILED DESCRIPTION OF EMBODIMENTS

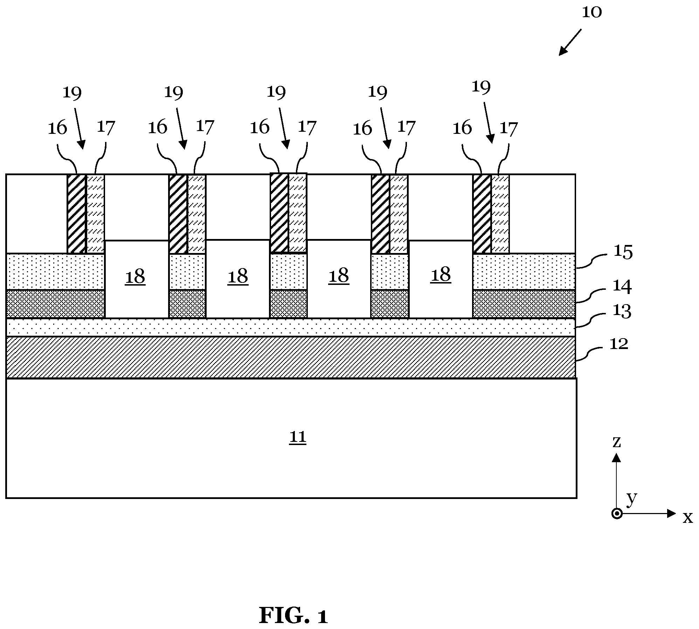

FIG. 1 shows a schematic diagram of a NAND flash memory device 10 according to an embodiment.

The NAND flash memory device 10 comprises: a semiconductor channel layer 12 extending along a first axis; a first dielectric layer 13 arranged above the semiconductor channel layer, a charge storage layer 14 arranged on the first dielectric layer 13; a second dielectric layer 15 arranged on the charge storage layer 14; and a plurality of gate structures 19 arranged above the second dielectric layer 15 and along the first axis; wherein each gate structure 19 comprises a first section 16 and a second section 17, wherein the first section 16 and the second section 17 are designed to have different work functions, and wherein the first section 16 and the second section 17 are arranged next to each other along the first axis.

Thus, the memory device 10 can have a split gate design with two segments respectively sections 16, 17 for each gate structure 19. The work function (or Fermi level) of one section 16 can have a beneficial alignment with the second dielectric layer 15 for electron injection, while the other section 17 can have a beneficial alignment with the layer 15 for hole injection. During programming (i.e., writing), electrons can be injected into the charge storage layer 14 via the first section 16, while the other section 17 is not injecting significant charge. During erasing, the situation reverses, with holes now being injected via the second section 17.

The first dielectric layer can be a blocking oxide layer. For instance, this blocking oxide layer prevents charge leakage from the charge storage layer. The first dielectric layer could be formed from an oxide material (e.g., SiO₂) with optionally a high-k liner of AL₂O₃ or HfO₂.

The second dielectric layer can be a tunnel oxide layer. This tunnel oxide allows controlled charge carrier tunneling during program and erase operations. For instance, the second dielectric layer is a silicon oxynitride (SiON) layer with an N content of up to 20%.

The channel layer 12 can be made of silicon, in particular poly-Si in a 3D string or monocrystalline silicon in a planar cell. The channel layer 12 may be arranged on a substrate 11, such as an oxide substrate.

The first axis can correspond to the channel direction, i.e., the x-axis in the indicated Cartesian coordinate system in FIG. 1.

The first section 16 and the second section 17 of each gate structure 19 can comprise different materials and/or different dopings.

For example, the first section 16 and/or the second section 17 of each gate structure 19 comprise a poly-silicon material, a metal or a metal nitride.

For instance, the first and the second sections 16, 17 can each be formed by a highly doped polysilicon (poly-Si) or a metal. For such a material, the Fermi level can be heavily shifted toward the conduction band side (in case of n-type metal/doping) or to the valence band side (in case of p-type metal/doping). The first section 16 can be made of an n-type material which highly benefits electron injection (e.g., n+ poly-Si), and the second section 17 can be made of a p-type material which highly benefits hole injection (e.g., p+ poly-Si).

The metal can be any one of W, Ti, Ta, Al, Mo Ru, Co, Cu, Ir, or Pt. The metal nitride can be any one of TiN or TaN.

Instead of an all-metal or all-poly-Si gate, the gate could consist of a combination of metal and poly-Si segments. This might enable a greater variety of work function differences between the segments and thus a wider window for optimization of the injection of the two carrier types.

For instance, the work function of the first section 16 of the respective gate structures 19 ranges from 3.5. to 5 eV. This can benefit the electron injection into the charge storage layer 14 via the first section 16. The work function of the second section 17 of the respective gate structures 19 can range from 4.5 to 6 eV. This can benefit the hole injection into the charge storage layer 14 via the second section 17.

For example, the work functions of the first section and the second section of the respective gate structures 19 differ by at least 0.5 eV, preferably by at least 1 eV. Preferably, the difference is between 1 and 2 eV.

The following table shows exemplary materials for the first and/or the second section 16, 17 together with their work functions (WF) respectively work function ranges of:

| **Material** | **WF [eV]** |
|---|---|
| p-type silicon highly doped | 5.1 |
| n-type silicon highly doped | 4.1 |
| W | 4.32 - 4.55 |
| Ti | 4.33 |
| Ta | 4.00 - 4.80 |
| TiN | 4.65 - 4.5 |
| ALD grown TiN | 4.7 - 4.9 |
| TaN | 4.55 |
| ALD grown TaN | 4.06 - 4.45 |
| Al | 4.06 4.26 |
| Mo | 4.36 - 4.95 |
| Ru | 4.71 |
| Co | 5 |
| Cu | 4.53 - 5.10 |
| Ir | 5.00 - 5.67 |
| Pt | 5.12 - 5.93 |
| NiSi(010) | 4.6 - 5.0 |
| PtSi(010) | 4.9 - 5.0 |

Besides the material itself, the work function of a material can depend on further factors, such as the deposition method or the layer thickness.

Optionally, the charge storage layer 14 may comprise a plurality of gaps 18 which are arranged to interrupt the charge storage layer 14. The gaps 18 and the gate structures 19 can be alternately arranged along the first axis. In this way, the injected carriers (electron and holes) can be confined efficiently to a limited volume underneath the respective gates. This limited volume may be referred to as charge trap regions.

The gaps 18 can be formed by cuts in the charge storage layer 14 (also referred to as: "charge trap layer" or CTL), such that the injected carriers are confined to a limited volume underneath the gates. As the electric field is highest around the gate corners, carriers are preferentially injected from those corners, which means the main points of injection of the carriers into the CTL 14 are separated by the gate length. With a scaled gate length and gaps 18 in the CTL 14, the carriers can fully occupy the limited volume, such that recombination can occur as in conventional erase. For instance, in the absence of a CTL cut, the electric field is such that the carriers could be pushed to migrate to the intergate spacing region, which would increase the separation between the two carrier types. By forming charge trap regions via the gaps 18, this migration can be avoided.

The gaps 18 can extend to the second dielectric layer 15 as shown in FIG. 1. However, the gaps 18 could also extend to the first dielectric layer 13.

The gaps 18 (CTL cuts) can be formed by an air gap. However, the gaps 18 could also comprise oxide material, or a combination of air gap and oxide.

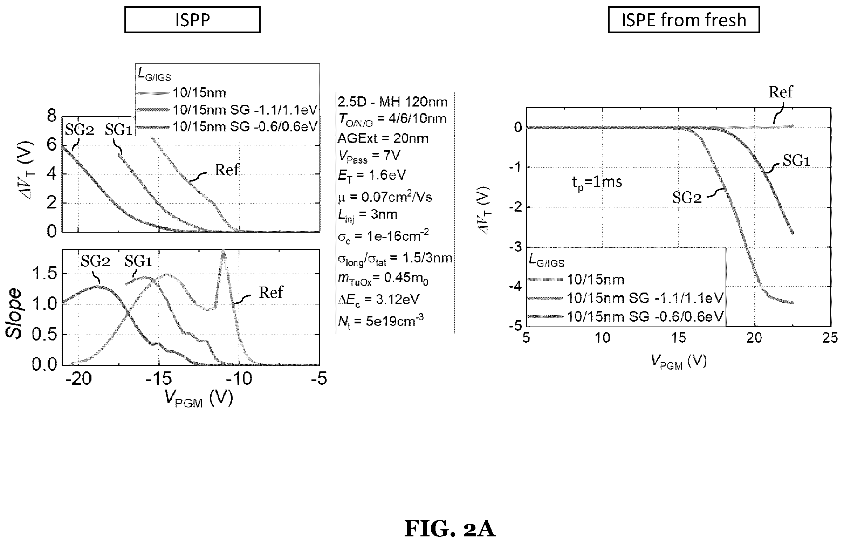

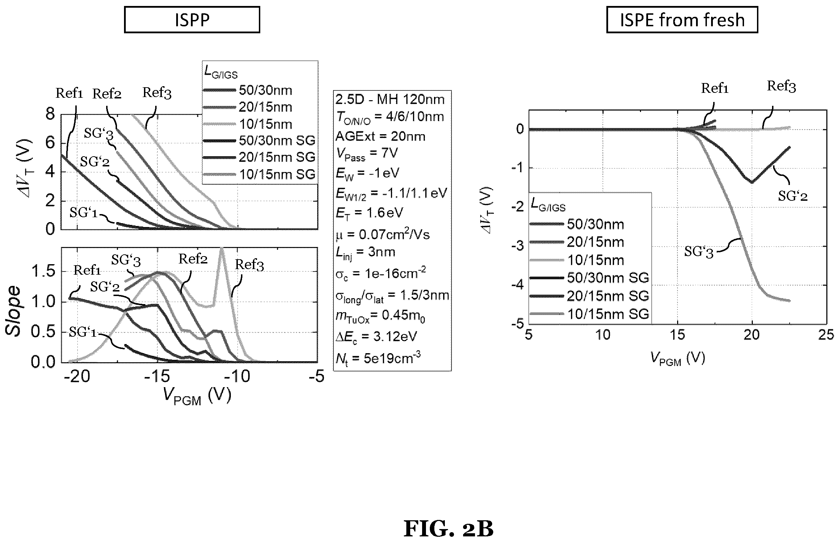

FIGS. 2A and 2B show results of simulations of memory operations in NAND flash memory devices according to an embodiment.

The left plots in FIGS. 2A and 2B show a programming of NAND flash memories with different gate designs via incremental step pulse programming (ISPP). During ISPP, a set of pulses with increasing amplitude is applied to the gate to achieve a threshold voltage target. Thereby, the plot on the top left shows the threshold voltage shift ΔV_{T} relative to a fresh state as a function of the pulse amplitude V_{PGM}. The plot on the bottom left shows the corresponding slope of the change of ΔV_{T}. The box to the right side of the two left plots indicates some simulation parameters.

The plot on the right in FIGS. 2A and 2B shows the corresponding erasing operation in the same memory structures via an incremental step pulse erasing (ISPE) process.

The simulations in FIG. 2A were carried out with NAND flash memory devices 10 with three different split gate configurations:
- A split gate with a work function difference between the first section 16 and the second section 17 of -1.1/1.1 eV, referred to as SG1 in the plots.
- A split gate with a work function difference between the first section 16 and the second section 17 of -0.6/0.6 eV, referred to as SG2 in the plots.
- A full gate reference with both sections 16, 17 having the same work function, referred to as Ref in the plots.

Hereby, the values -1.1/1.1 eV and -0.6/0.6 eV refer to a Si midgap reference, i.e., the -1.1/1.1 eV case represents a WF difference of 2.2 eV, while the -0.6/0.6 eV case represents a WF diff of 1.2 eV.

In each case, the sections 16, 17 have a length of 5 nm along the first axis (channel direction). The "10/15nm" in the legend indicates a total gate length of 10 nm and intergate spacing of 15 nm.

The simulation results in FIG. 2A show that the split gate design with different work functions trades some ISPP performance for a strong ISPE improvement at certain scaled dimensions. However, the split gate designs still achieve an ISPP slope > 1. The simulations further indicate that stronger work function difference between the gate sections 16, 17 improves the benefit.

The simulations in FIG. 2B were carried out with NAND flash memory devices 10 with six different split gate configurations with different gate length and gate spacings:
- A split gate with a gate length of 50 nm split into two sections 16, 17 of width 25 nm, referred to as SG'1 in the plots.
- A split gate with a gate length 20 nm split into two sections 16, 17 of width 10 nm, referred to as SG'2 in the plots.
- A split gate with a gate length of 10 nm split into two sections 16, 17 of width 5 nm, referred to as SG'3 in the plots.
- Three full gate references with the same geometries as SG'1 to SG'3 and no work function differences in the gate sections, referred to as Ref1 to Ref 3 in the plots.

For each split gate SG'1-SG'3, the work function difference between the first section 16 and the second section 17 is -1.1/1.1 eV.

The simulation results in FIG. 2B show a clear advantage of the split gate designs in ISPE at the cost of some performance in ISPP. The full gate devices Ref1 to Ref3 show a steep ISPP slope and early onset, with even steeper slope and earlier onset at more scaled gate lengths. There is, however, no appreciable erase in the ISPE characteristic for the full gates, with the most scaled case Ref1 even showing a slight programming behavior. For the split gates SG'1-SG'3, the ISPP slope is not as steep and the programming onset not as early as for the full gates, but the slope is still above 1 for the most scaled gate lengths. However, the split gates, in particular SG'3 and SG'2, show a strong advantage in the ISPE characteristic, with significant erase behavior, similar to conventional channel side operation.

These simulation results show that varying the widths of the gate sections allows for a further optimization of the memory operation.

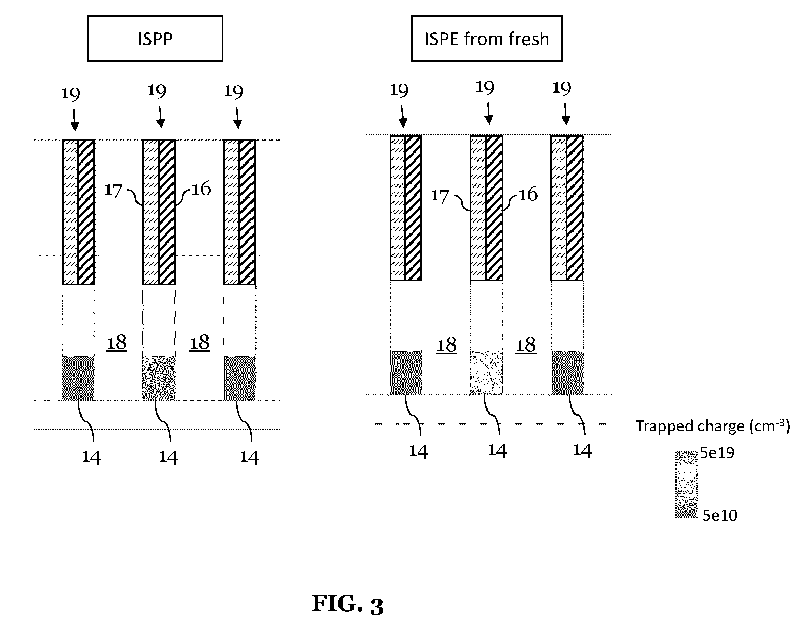

FIG. 3 shows simulations of charge carrier injection in the charge storage layer 14 below the gate structures 19 of the NAND flash memory device 10 and, in particular, the distribution of the trapped charges according to an embodiment. In contrast to FIG. 1, in FIG. 3 the first section 16 of each gate structure 19 is on its right side and the second section 17 on its left side.

For instance, during programming (ISPP on the left of FIG. 3), a first bias is applied to at least one of the gate structures 19 to allow negative charge carriers, in particular electrons, to inject into the charge storage layer 14 below the gate structure 19 via the first section 16 of the gate structure. In the simulation of FIG. 3, the bias is applied to the center gate structure 19. At least a portion of the injected negative charge carriers are stored in the charge storage layer 14 below the gate structure, as indicated by the charge distribution profile in FIG. 3.

In contrast, during erase (ISPE on the right of FIG. 3), a second bias is applied to the gate structures 19 to allow positive charge carriers, in particular holes, to inject into the charge storage layer 14 via the second section 17 of the gate structure. At least a portion of these positive charge carriers recombine with the negative charge carriers stored in the charge storage layer 14.

The trapped charge profiles in FIG. 3 confirm that both carrier types (electron and holes) can be injected from the split gate, with the electrons being injected from the corner of the low work function side of the gate (e.g., the first section 16), and the holes from the corner of the high work function side of the gate (e.g., the second section 17). Despite the separation of the dominant injection points, both carrier types spread throughout the limited volume of the charge trap regions which are confined by the cuts 18 (e.g., air gaps).

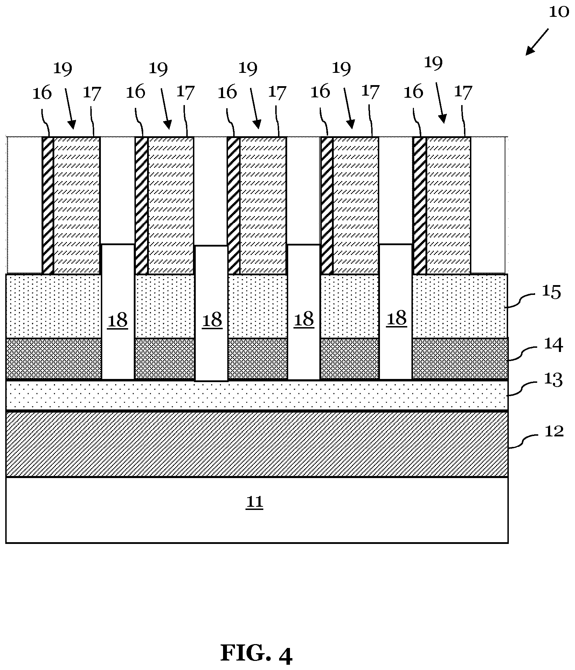

Fig. 4 shows the NAND flash memory device 10 according to an embodiment, wherein the first and the second section 16, 17 of the respective gate structures 19 have different widths along the first axis (i.e., along the channel direction).

This "thickness" of the gate structures or segments could be adapted depending on the requirements of the ISPP and ISPE behavior of a memory cell. The ISPP operation is typically more critical, so the segment for electron injection might be larger than that for hole injection.

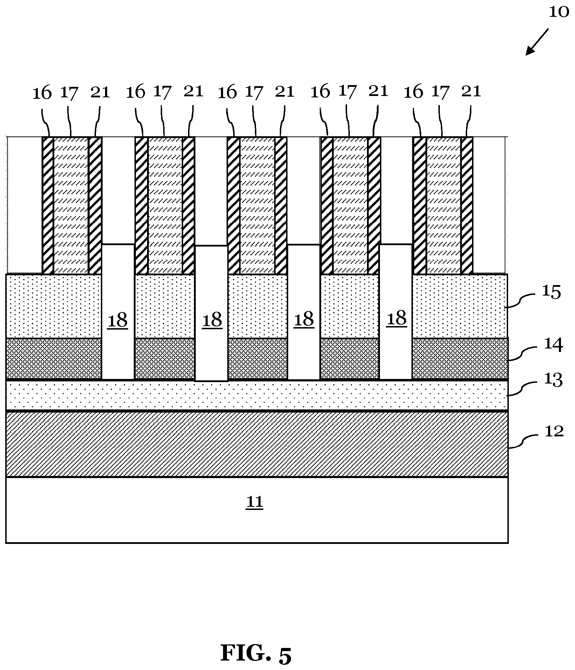

Fig. 5 shows the NAND flash memory device 10 according to an embodiment, wherein each gate structure comprises a third section 21 which is arranged next to the second section 17 along the first axis.

The third section 21 can be designed to have essentially the same work function as the first section 16, or to have a work function that differs from the work function of the first section 16 by less than 0.1 eV.

For example, the first section 16 and the third section 21 of the respective gate structures are made from the same material(s) and/or with the same width along the first axis.

The sections 16, 17, 21 could form a sandwich structure, with the material injecting the electrons on the outside (sections 16 and 21), and the hole injecting material on the inside (section 17). This could provide two corners for the electron injection, where the electric field is enhanced. This would benefit the program operation, possibly at the expense of the erase operation. However, in case the erase operation is less critical, this might be a worthwhile trade-off.

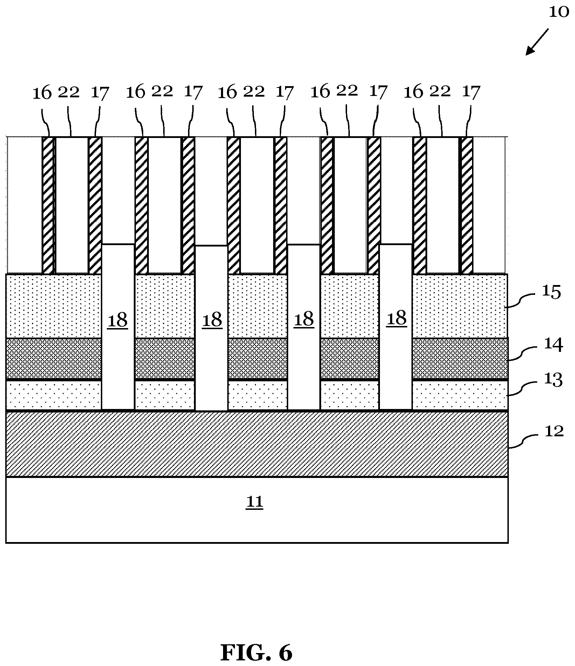

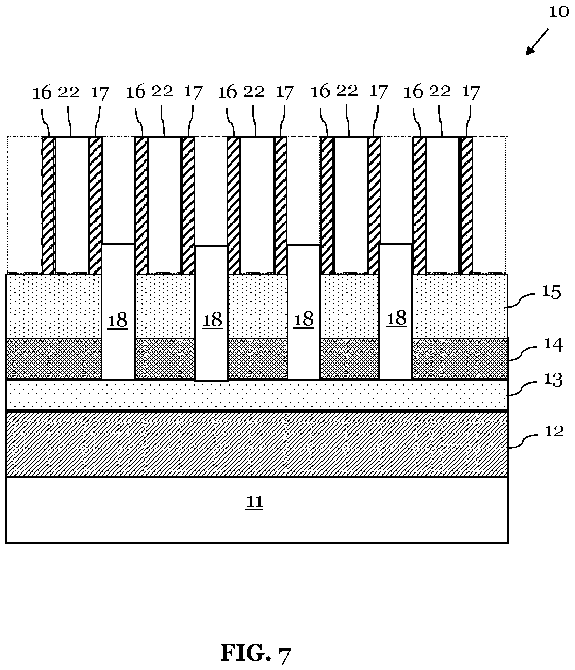

FIGS. 6 and 7 show further exemplary NAND memory devices 10 with "sandwich" split gate designs.

In these examples, an isolating layer 22 is arranged between the first and the second gate sections 16, 17, e.g., according to an MIM (metal-isolator-metal) configuration.

In the example shown in FIG. 6, the gap 18, e.g. the air gap, extends through the charge storage layer 14 as well as the first and the second dielectric layers 13, 15. In the example shown in FIG. 7, the gap 18 only extends through the charge storage layer 14 and the second dielectric layer 15.

In summary, the above-described design of a NAND flash memory device 10 improves erase performance in NAND flash cells that employ gate side injection, by splitting the gate in multiple segments or sections. Each segment can be optimized for the injection of different carrier types by a proper selection of work functions (in case of metals) or doping types (in case of poly-Si).

It is to be noted that while FIGS. 1 and 3 to 7 show the NAND flash memory device 10 as a planar (2D) device, this is mostly for the sake of simplicity. The NAND flash memory device 10 can also have a vertical (3D) design.

According to a further embodiment, a NAND flash memory structure comprises a gate structure with an isolating layer 22 that is arranged between two gate sections 16, 17 made of the same material and/or having essentially the same work functions. Thereby, for example, only the electrons are injected from the gate side for the programming (write). Such an arrangement of an isolating layer 22 can result in a two-slope ISPP curve, with a high slope being more significant for isolating layers 22 with smaller width.

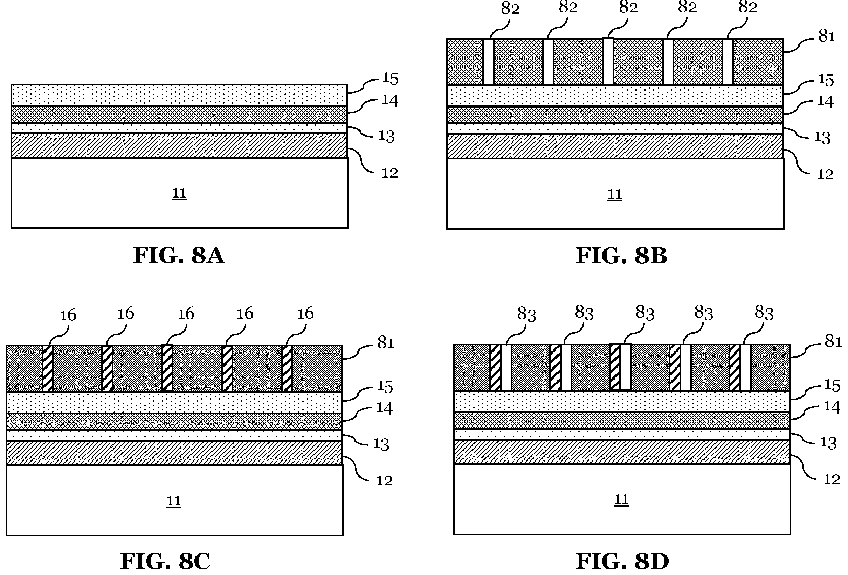

FIGS. 8A to 8F show steps of a method for fabricating the NAND flash memory device 10 according to an embodiment. These figures are highly schematic and depict an exemplary planar (2D) structure. When fabricating a vertical (3D) memory structure, additional fabrication steps, not shown in FIGS. 8A to 8F, may be added and/or the sequence of the fabrication steps may differ.

The method comprises, as shown in FIG. 8A, the formation of the following layers: the semiconductor channel layer 12, which extends along the first axis; the first dielectric layer 13 above the semiconductor channel layer; 12 the charge storage layer 14 on the first dielectric layer 13; and the second dielectric layer 15 on the charge storage layer 14. Each of these layers can be formed by a suitable deposition process.

For instance, the semiconductor channel layer 12 can be formed on a substrate 11, such as an oxide substrate.

In case of a 3D memory design, the channel layer 12, as well as the further layers 13, 14 and 15 can be deposited in a memory hole (also referred to as: channel hole). The memory hole can be a cylindrical hole which is etched in a layer stack, e.g. a SiO₂/poly-Si or a SiNₓ/SiO₂ stack. The deposition of the layers 12-15 in the memory hole can be performed in reverse order, i.e., the second dielectical layer 15 can be deposited first and the channel layer 12 deposited last in the memory hole. After the deposition of the channel layer 12, the remaining hole can be filled with a SiO₂ layer.

The method further comprises the formation of a plurality of gate structures 19 above the second dielectric layer and along the first axis, wherein each gate structure comprises the first and the second section 16, 17 which are designed to have different work functions and are arranged next to each other along the first axis.

A possible processes for the formation of these gate structures 19 is shown in FIGS. 8B to 8E. In case of a 3D memory design, the gate 19 structures can be fabricated prior to the formation of at least some of the layers 12-15.

As shown in FIG. 8B, a sacrificial layer 81 can be deposited on the second dielectric layer 15, and a first part of the sacrificial layer 81 can be selectively removed to expose a first area 82. The first area 82 can comprise a number of cavities in the sacrificial layer 81.

Then, as shown in FIG. 8C, the material of the first section 16 of the gate structure can be deposited in the first area 82, e.g., in the cavities.

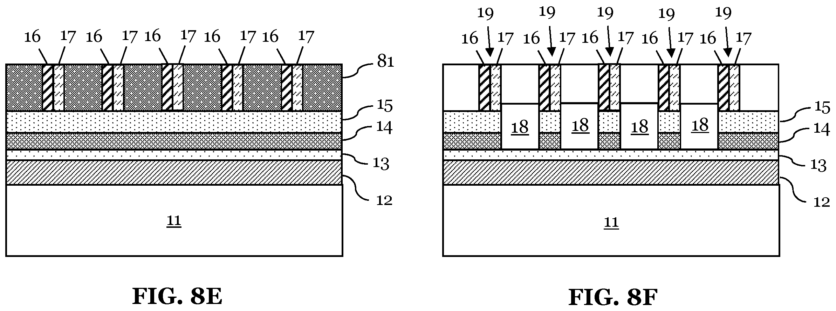

Subsequently, as shown in FIG. 8D, a second part of the sacrificial layer 81 can be removed to expose a second area 83, and, as shown in FIG. 8E, the material of the second section 17 of the gate structure can be deposited in the second area 83. The second area 83 can comprise a number of further cavities in the sacrificial layer 81.

In this way, a number of gate structures 19 can be formed, wherein each gate structure comprises the first section 17 and the second section 17, wherein the sections 16, 17 are arranged next to each other along the first axis and are designed to have different work functions.

For instance, the process steps shown in FIG. 8B to 8E can correspond to a replacement metal gate (RMG) flow, where a differentiation is made for the etch rate of the sacrificial layer 81. For example, the first part and the second part of the sacrificial layer 81 are each removed via etching with an etchant, wherein the first part is etched with a higher etching rate than the second part.

One way to achieve this is by varying the composition of the sacrificial layer, e.g. the N content in a SiN sacrificial layer. The RMG process would then proceed in two steps: first, the etching of the high-etch rate part of the sacrificial layer 81 and the deposition of the material of the first section 16 (e.g., a first gate metal), as shown in FIGS. 8B and 8C. Subsequently, the etching of the low-etch rate part of the sacrificial layer 81 and the deposition of the material of the second section 17 (e.g., second gate metal), as shown in FIGS. 8D and 8E. Between the two steps, the material of the first section 16 in the RMG trench could be etched back, such that it is only present in the gate cavity. The material of the second section 17 could then fill up the remainder of the gate cavity and the RMG trench.

As shown in FIG. 8F, the method may comprise the further step of forming the plurality of gaps 18 in the charge storage layer 14, wherein the gaps 18 are arranged to interrupt the charge storage layer 14, and wherein the gaps 18 and the gate structures 19 are alternately arranged along the first axis (i.e., the channel direction). The gaps 18 could also be formed in an earlier step, e.g. prior to the formation of the gate structures 19.

In case of a 3D memory design, these gaps 18 can be air gap structures which are formed in the side walls of a memory hole. For instance, the basic steps of forming a 3D NAND memory structure with such air gap structures comprises the following steps: forming a layer stack over a substrate, the layer stack comprising an alternating sequence of gate layers and inter-gate spacer layers; forming first recessed areas in a sidewall surrounding a memory hole in the layer stack by laterally etching back the gate layers from the memory hole; forming a lateral memory stack in each first recessed areas, by depositing a blocking oxide and, subsequently, a charge trap material; forming second recessed areas in the sidewall by laterally etching back the inter-gate spacer layers from the memory hole; forming dummy layers in the second recessed areas; after forming the lateral memory stack and the dummy layers, lining the sidewall of the memory hole with a liner layer; after lining the sidewall, subjecting the dummy layers to a thermal treatment process adapted to convert each dummy layer into an air gap structure, wherein the air gap structures are formed laterally between the liner layer and the inter-gate spacer layers; forming a tunneling oxide layer in the memory hole, along the liner layer; and forming a channel layer along the tunneling oxide layer. The phase "air gap structure" hereby refers to a space or void enclosed by a pair of lateral memory stacks, the liner layer and an inter-gate spacer layer.

Thereby, the layer stack can be formed over a substrate and comprises an alternating sequence of gate layers and inter-gate spacer layers. The gate layers may be nitride-comprising layers, such as SiN layers, thus forming sacrificial gate layers intended to be replaced by an RMG stack in subsequent process steps. The inter-gate spacer layers may be oxide-comprising layers, such as SiO2 layers or another suitable inter-layer dielectric (e.g. of low-k). The liner layer may be a low thermal oxide (LTO), such as LTO SiO₂.

The treatment process to convert each dummy layer into an air gap structure may be performed by performing a thermal anneal (e.g. in a reactor chamber or furnace). The thermal energy needed to achieve a sufficient conversion ratio is, as would be understood by the skilled person, dependent on the specific dummy material of the dummy layers. For example, for any of the above examples of dummy materials, heating the structure or an ambient of the structure to about 500 °C will typically be sufficient to completely convert the dummy layers 24 without any appreciable formation of residues in the resulting air gaps.

The lateral depth or extent of the air gap structures can be determined by the lateral thickness or extent of the dummy layers, and accordingly of the lateral depth or extent of the second recessed areas.

In the claims as well as in the description of this disclosure, the word "comprising" does not exclude other elements or steps and the indefinite article "a" or "an" does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. A NAND flash memory device (10), comprising:
a semiconductor channel layer (12) extending along a first axis;
a first dielectric layer (13) arranged above the semiconductor channel layer (12);
a charge storage layer (14) arranged on the first dielectric layer (13);
a second dielectric layer (15) arranged on the charge storage layer (14); and
a plurality of gate structures (19) arranged above the second dielectric layer (15) and along the first axis;
wherein each gate structure (19) comprises a first section (16) and a second section (17), wherein the first section (16) and the second section (17) are designed to have different work functions, and wherein the first section (16) and the second section (17) are arranged next to each other along the first axis.

2. The NAND flash memory device (10) of claim 1,
wherein the charge storage layer (14) comprises a plurality of gaps (18) which are arranged to interrupt the charge storage layer (14);
wherein the gaps (18) and the gate structures (19) are alternately arranged along the first axis.

3. The NAND flash memory device (10) of claim 2,
wherein the gaps (18) are at least partially filled with air and/or an oxide material.

4. The NAND flash memory device (10) of any one of the preceding claims,
wherein the charge storage layer (14) comprises a silicon nitride material.

5. The NAND flash memory device (10) of any one of the preceding claims,
wherein the work function of the first section (16) of the respective gate structures (19) ranges from 3.5. to 5 eV; and/or
wherein the work function of the second section (17) of the respective gate structures (19) ranges from 4.5 to 6 eV.

6. The NAND flash memory device (10) of any one of the preceding claims,
wherein the work functions of the first section (16) and the second section (17) of the respective gate structures (19) differ by at least 0.5 eV, preferably by at least 1 eV.

7. The NAND flash memory device (10) of any one of the preceding claims,
wherein the first section (16) and the second section (17) of the respective gate structures (19) comprise different materials and/or different dopings.

8. The NAND flash memory device (10) of any one of the preceding claims,
wherein the first section (16) and/or the second section (17) of the respective gate structures (19) comprise a poly-silicon material, a metal or a metal nitride.

9. The NAND flash memory device (10) of any one of the preceding claims,
wherein the first section (16) and the second section (17) of the respective gate structures (19) have different widths along the first axis.

10. The NAND flash memory device (10) of any one of the preceding claims,
wherein the respective gate structures (19) comprise an isolating layer which is arranged between the first section (16) and the second section (17).

11. The NAND flash memory device (10) of any one of the preceding claims,
wherein each gate structure (19) comprises a third section (21) which is arranged next to the second section (17) along the first axis;
wherein the third section (21) is designed to have the same work function as the first section (16), or wherein the third section (21) is designed to have a work function that differs from the work function of the first section (16) by less than 0.1 eV.

12. A method for operating the NAND flash memory device (10) of any one of the preceding claims, wherein the method comprises:
applying a first bias to at least one of the gate structures (19) to allow negative charge carriers, in particular electrons, to inject into the charge storage layer (14) below the gate structure (19) via the first section (16) of the gate structure, wherein at least a portion of the negative charge carriers are stored in the charge storage layer (14); and
applying a second bias to the at least one of the gate structures (19) to allow positive charge carriers, in particular holes, to inject into the charge storage layer (14) below the gate structure (19) via the second section (17) of the gate structure, wherein at least a portion of the positive charge carriers recombine with the negative charge carriers stored in the charge storage layer (14).

13. A method for fabricating a NAND flash memory device (10), the method comprising:
forming a semiconductor channel layer (12) extending along a first axis;
forming a first dielectric layer (13) arranged above the semiconductor channel layer (12);
forming a charge storage layer (14) arranged on the first dielectric layer (13);
forming a second dielectric layer (15) arranged on the charge storage layer (14); and
forming a plurality of gate structures (19) arranged above the second dielectric layer (15) and along the first axis;
wherein each gate structure (19) comprises a first section (16) and a second section (17), wherein the first section (16) and the second section (17) are designed to have different work functions, and wherein the first section (16) and the second section (17) are arranged next to each other along the first axis.

14. The method of claim 13, further comprising:
forming a plurality of gaps (18) in the charge storage layer (14);
wherein the gaps (18) are arranged to interrupt the charge storage layer (14); and
wherein the gaps (18) and the gate structures (19) are alternately arranged along the first axis.

15. The method of claim 13 or 14,
wherein the formation of the respective gate structures (19) comprises:
depositing a sacrificial layer (81) above the second dielectric layer (15),
selectively removing a first part of the sacrificial layer to expose a first area (82) and depositing a material of the first section (16) of the gate structure in the first area (82), and
removing a second part of the sacrificial layer (81) to expose a second area (83) and depositing a material of the second section (17) of the gate structure in the second area (83).

16. The method of claim 15,
wherein the first part and the second part of the sacrificial layer (81) are each removed via etching with an etchant, wherein the first part is designed to be etched with a higher etching rate than the second part.
